# EUROPEAN PATENT APPLICATION

(11) **EP 4 697 051 A1**
(43) Date of publication of application: **18.02.2026**
(21) Application number: 24194686.2
(22) Date of filing: 15.08.2024
(51) Int. Cl.: G01R 33/54, G01R 33/50

(54) **PARAMETER ADJUSTMENT DURING A MEDICAL IMAGING SCAN**

(71) Applicant: Koninklijke Philips N.V., 5656 AG Eindhoven (NL)
(72) Inventor: DONEVA, Mariya Ivanova, Eindhoven (NL); AMTHOR, Thomas Erik, Eindhoven (NL)
(74) Representative: Philips Intellectual Property & Standards

(57) **Abstract**

Image quality degradation caused by improper setting of sequence parameters compromises the ability of radiologists and image processing techniques to process medical images. Provided is therefore a computer-implemented method for providing real-time feedback on parameter adjustment during a medical imaging scan sequence. The method comprises: displaying a graphical user interface for interaction with a user, wherein the graphical user interface comprises at least one input element configured to allow adjustment of at least one sequence parameter for defining the medical imaging scan sequence; in response to adjustment of the at least one sequence parameter, determining at least one deviation of the at least one sequence parameter as adjusted from at least one corresponding standard setting; displaying to the user real-time feedback concerning the at least one deviation via at least one output element of the graphical user interface. By offering real-time feedback concerning the expected impact of the parameter adjustment on the resulting image, the efficiency and accuracy of medical imaging can be improved.

## Description

### FIELD OF THE INVENTION

The invention relates to methods and systems for providing real-time feedback on parameter adjustment during a medical imaging scan sequence.

### BACKGROUND OF THE INVENTION

Magnetic resonance imaging (MRI) is a non-invasive imaging technology widely used in medical diagnostics to produce detailed images of the internal structures of the body. MRI scanners are operated by adjusting various sequence parameters to define a scan sequence. A complex interplay exists between the numerous parameters and the quality and appearance of the resulting image. Inexperienced operators, being unaware of this, may inadvertently cause image quality degradation by improper setting of the sequence parameters. Image quality degradation compromises the ability of radiologists and image processing techniques to process the images.

### SUMMARY OF THE INVENTION

To better address one or more of these concerns, there is provided, in a first aspect of invention, a computer-implemented method for providing real-time feedback on parameter adjustment during a medical imaging scan sequence. The method comprises:
displaying a graphical user interface for interaction with a user, wherein the graphical user interface comprises at least one input element configured to allow adjustment of at least one sequence parameter for defining the medical imaging scan sequence;
in response to adjustment of the at least one sequence parameter, determining at least one deviation of the at least one sequence parameter as adjusted from at least one corresponding standard setting;
displaying to the user real-time feedback concerning the at least one deviation via at least one output element of the graphical user interface.

The method may further comprise determining an impact of the at least one deviation on a medical image to be acquired during the medical imaging scan.

Determining the impact of the at least one deviation may simply comprise using the deviation itself as an impact indicator. Thus, the real-time feedback concerning the at least one deviation may comprise an indication of the severity or magnitude of the at least one deviation from the at least one corresponding standard (or pre-established) setting. In this way, a readily determinable impact indicator is provided.

The method may further comprise determining an impact of the at least one deviation on an intended contrast type, wherein the at least one output element of the graphical user interface displays to the user real-time feedback concerning the determined impact on the intended contrast type. In particular, the determined impact on the intended contrast type may comprise an amount of T1 contrast or an amount of T2 contrast.

The method may further comprise determining an impact of the at least one deviation on at least one image quality metric, wherein the at least one output element of the graphical user interface displays to the user real-time feedback concerning the determined impact on the at least one image quality metric. In particular, the at least one image quality metric may comprise signal-to-noise ratio, strength of contrast, undersampling artifact strength, amount of geometric distortion, spatial resolution, temporal resolution, or sensitivity to motion, and so on.

The determined impact of the at least one deviation may be indicated to the user via the at least one output element using various different impact indicators. In one non-limiting example described further herein, the at least one output element of the graphical user interface comprises a bar with a movable marker as an impact indicator indicating a severity of the impact. The bar may furthermore be color-coded to provide a further indication of severity. Other forms of impact indicator are conceivable. By way of example, the impact indicator may comprise one or more of: a needle on a gauge chart, or another form of dashboard-type visualization; a simple number display, e.g. showing a number between - 1 and 1, with 0 being closest to the standard setting; a traffic light display indicating the deviation from the setting standard (in this case, unidirectional); a spider web chart showing multiple indicators at the same time; a non-color-coded bar showing a movable marker, for example on a scale.

The method may further comprise carrying out simulation or modelling of a medical imaging system which is to perform the medical imaging scan sequence to determine the impact of the at least one deviation. The method may further comprise accessing a database storing the at least one standard setting.

The at least one standard setting may be derived from a protocol. Multiple versions of the protocol may exist, and the method may further comprise selecting one of the versions of the protocol based on an image quality comparison between the multiple versions.

The method may further comprise enabling the user to lock the at least one sequence parameter to prevent unintended adjustment thereof.

The method may further comprise using the graphical user interface to collect user feedback concerning at least one reason for the adjustment of the at least one sequence parameter.

The method may further comprise outputting an alert to the user concerning the at least one deviation.

The method may further comprise storing data related to the at least one deviation as metadata with a medical image acquired during the medical imaging scan sequence.

The at least one sequence parameter may relate to any one or more of: echo time (TE), repetition time (TR), inversion time, flip angle, resolution, a setting of an acquisition acceleration technique, a reconstruction parameter setting, etc.

According to a second aspect, there is provided a computing system configured to perform the method of the first aspect. The computing system can typically comprise a processor, for example a processor that is part of a computer.

According to a third aspect, there is provided a computer program (product) comprising instructions which, when executed by a computing system, enable or cause the computing system to perform the method of the first aspect.

According to a fourth aspect, there is provided a computer-readable (storage) medium comprising instructions which, when executed by a computing system, enable or cause the computing system to perform the method of the first aspect. The computer-readable medium may be transitory or non-transitory, volatile or non-volatile.

Methods and systems described herein provide assistance to users of MRI scanners by offering real-time feedback concerning the impact of parameter adjustments on image quality, thereby improving the efficiency and accuracy of MRI scanning. Methods and systems described herein reduce the need for users of MRI scanners to have extensive technical knowledge by embedding an intuitive, user-friendly feedback system within the MRI scanner's GUI.

The term "user" as used herein may refer to any user of a medical imaging system and may in certain contexts denote a technologist, operator, or radiographer, for example.

The term "adjustment" as used herein refers to any change in a sequence parameter which may be directly or indirectly put into effect. For example, the adjustment may be made: directly by the user explicitly changing (the value of) that parameter; directly by the user importing settings, where the changes may have been introduced using a different system; indirectly by the user making another change that is linked to the said parameter; or indirectly as a consequence of software modifications, of which the user may not even be even aware. By monitoring for any changes in sequence parameters, regardless of the origin of the change, any such adjustment can readily be detected.

The term "deviation" as used herein refers to the difference between the value of a parameter input by the user and a reference value or standard setting available from a predefined protocol.

The term "impact" as used herein refers to the consequence of the deviation, expressed in terms of a metric which represents image quality or appearance. The deviation may itself serve to quantify the impact.

The term "determining", as used herein, may encompass calculating, computing, processing, deriving, investigating, resolving, selecting, choosing, ascertaining, establishing, looking up (e.g., looking up in a table, a database or another data structure), receiving (e.g., receiving information), accessing (e.g., accessing data in a memory), and the like.

The indefinite article "a" or "an" does not exclude a plurality. In addition, the articles "a" and "an" as used herein should generally be construed to mean "one or more" unless specified otherwise or clear from the context to be directed to a singular form.

Unless specified otherwise, or clear from the context, the phrases "one or more of A, B and C", "at least one of A, B, and C", and "A, B and/or C" as used herein are intended to mean all possible permutations of one or more of the listed items. That is, the phrase "A and/or B" means (A), (B), or (A and B), while the phrase "A, B, and/or C" means (A), (B), (C), (A and B), (A and C), (B and C), or (A, B, and C).

The term "comprising" does not exclude other elements or steps. Furthermore, the terms "comprising", "including", "having" and the like may be used interchangeably herein.

The invention may include one or more aspects, examples or features in isolation or combination whether specifically disclosed in that combination or in isolation. Any optional feature or sub-aspect of one of the above aspects applies as appropriate to any of the other aspects.

The above-described aspects will become apparent from, and elucidated with, reference to the detailed description provided hereinafter.

### BRIEF DESCRIPTION OF THE DRAWINGS

A detailed description will now be given, by way of example only, with reference to the accompanying drawings, in which:
FIG. 1 illustrates a GUI for an MRI scanner which provides real-time feedback concerning the impact of sequence parameter adjustments;
FIG. 2 is a flowchart representing a method for providing real-time feedback on parameter adjustment during a medical imaging scan sequence; and
FIG. 3 illustrates a computing system that can be used in accordance with the systems and methods disclosed herein.

### DETAILED DESCRIPTION OF EMBODIMENTS

Image quality degradation caused by improper setting of sequence parameters compromises the ability of radiologists and image processing techniques to process medical images. Provided is therefore a computer-implemented method for providing real-time feedback on parameter adjustment during a medical imaging scan sequence. The method comprises: displaying a graphical user interface for interaction with a user, wherein the graphical user interface comprises at least one input element configured to allow adjustment of at least one sequence parameter for defining the medical imaging scan sequence; in response to adjustment of the at least one sequence parameter, determining at least one deviation of the at least one sequence parameter as adjusted from at least one corresponding standard setting; displaying to the user real-time feedback concerning the at least one deviation via at least one output element of the graphical user interface. By offering real-time feedback concerning the expected impact of the parameter adjustment on the resulting image, the efficiency and accuracy of medical imaging can be improved.

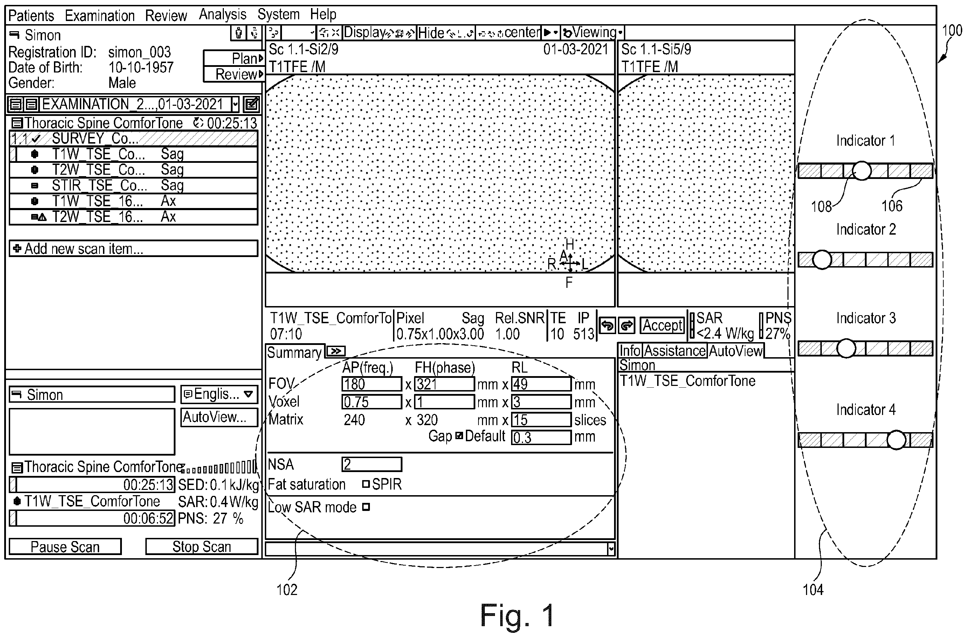

FIG. 1 illustrates a graphical user interface (GUI) 100 for a magnetic resonance imaging (MRI) scanner which provides real-time feedback concerning the impact of sequence parameter adjustments. The GUI 100 comprises input elements 102 configured to allow adjustment of sequence parameters for defining the MRI scan sequence. Real-time deviation analysis is carried out while the user is modifying the sequence parameters. Deviations from standard settings are evaluated and output elements 104 in the GUI 100 serving as impact indicators are updated in real time to indicate the impact of the deviations.

In the non-limiting example shown, four impact indicators 104 are evaluated and visualized by color-coded bars 106 indicating the expected severity of the impact on the resulting medical image. For example, a central portion of the bar 106 may be colored blue to indicate a minor or moderate impact, while the outer portions are colored red for severe impact. A marker 108 moves to the left or right of an optimal position or standard setting, represented by the center line of the bar 106, with the distance of the marker 108 from the center line providing an additional indication of the severity of the impact.

Various types of impact indicator 104 may be employed by the GUI 100.

In a first example, the deviation of an adjusted parameter from its corresponding standard setting (as defined by a protocol) is measured and used directly to indicate the impact. Stated differently, the magnitude of the measured deviation per se serves as an indicator of the impact of the adjustment.

In a second example, the impact indicator 104 indicates the impact of the measured deviation on an intended contrast type. This may be expressed as "amount of T1 contrast", "amount of T2 contrast", etc. The use of such impact indicators 104 may involve modelling the MRI signal contrast based on the sequence parameters as adjusted by the user.

In a third example, the impact indicator 104 indicates the impact of the measured deviation on an image quality metric. Such impact indicators 104 may be determined by simulating the MRI scanner, taking for example system imperfections and sampling artifacts into account. Examples of image quality metrics include signal-to-noise ratio, undersampling artifact strength, amount of geometric distortion, etc.

It will be appreciated that impact indicators 104 of varying type may be employed within the same GUI 100.

In a non-limiting use case, the methods and systems described herein are used to assist the standardization and consistency of a brain exam performed for the indication of multiple sclerosis. The exam card consists of a 3D T1W brain scan, a T2W scan, a 3D T2W FLAIR scan, as well as Gd enhanced T1W scan according to the 2021 MAGNIMS-CMSC-NAIMS consensus recommendations on the use of MRI in patients with multiple sclerosis. MRI scans need to be performed every 6-12 months while ensuring consistency between the scans performed at different times.
1. An exam card with standard settings for each protocol complying with the guidelines and the standard operating procedure (SOP) of the hospital or imaging center is defined and saved in a protocol standardization assistant. The standard settings include the full list of acquisition and reconstruction parameters that may influence the image appearance.
2. During patient examination, a comparison between the user-adjusted sequence parameters the standard settings and is performed.
3. Any deviations are visualized by the impact indicators 104 as described herein.
4. The evaluation and visualization are updated regularly whenever the user adjusts any of the sequence parameters.
5. Should a scan be executed in which a deviation from the standard setting falls above a pre-defined threshold, the user may be requested to provide feedback regarding the reasons for the protocol modifications.
6. The impact indicator values (optionally also the deviations from the standard settings) and (if available) the user-provided reasoning are stored as metadata together with the respective image data, for example by way of DICOM tags.

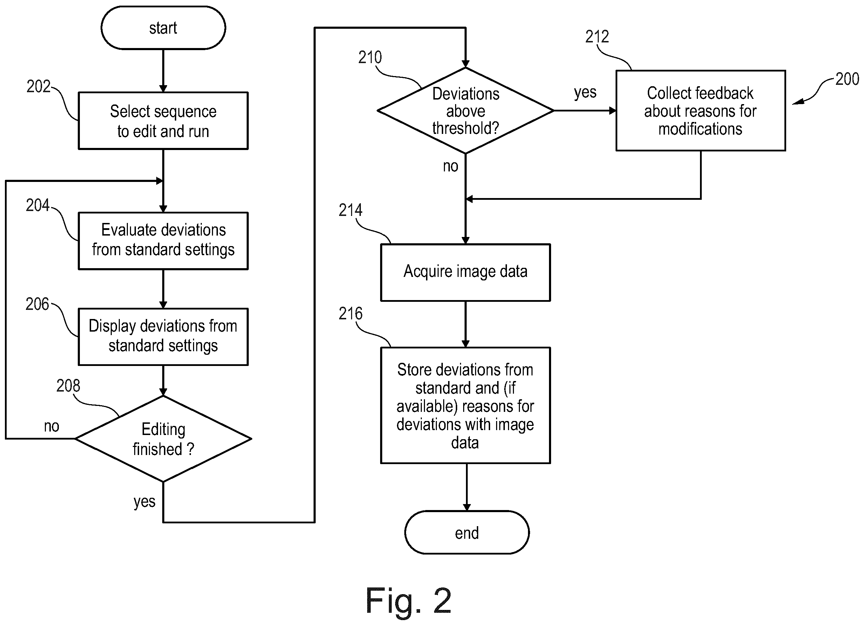

FIG. 2 illustrates the method for providing real-time feedback on parameter adjustment during a medical imaging scan sequence.

In step 202, the method begins by obtaining a user selection of a scan sequence to be edited and run.

In step 204, sequence parameter adjustments made by the user using the GUI 100 are evaluated in real time to determine deviations from the standard settings for the selected sequence.

In step 206, the impact indicators 104 are used to indicating to the user the impact of the deviations from the standard settings.

Steps 204 and 206 are repeated until a determination is made in step 208 that editing is finished.

When editing is finished, the method proceeds to optional step 210, in which a determination is made as to whether any deviations fall above respective predetermined thresholds.

In step 212, if any deviations fall above the thresholds, user feedback is collected regarding reasons for the modifications.

In step 214, the user-defined sequence is run to acquire image data.

In step 216, information regarding the deviations from standard settings and possibly also the collected reasons is stored as metadata along with the respective medical image.

Disclosed herein are systems and methods which provide real-time deviation analysis by measuring deviations from standard sequence parameters and indicating the impact of sequence parameter adjustments on image quality using the same GUI that is used for parameter adjustment, thereby assisting users in optimizing MRI scans. The real-time feedback enables users to make informed decisions and quickly optimize sequence parameters to achieve the desired image quality, thereby reducing the dependency on extensive technical knowledge, while making MRI scanning more efficient and accessible.

The methods and systems described herein find particular application in the field of MRI, with particular application to the standardization of MRI protocols, MRI image quality assurance, MRI protocoling, and MRI workflow. It will be appreciated, however, that the methods and systems are equally applicable to imaging applications outside of MRI.

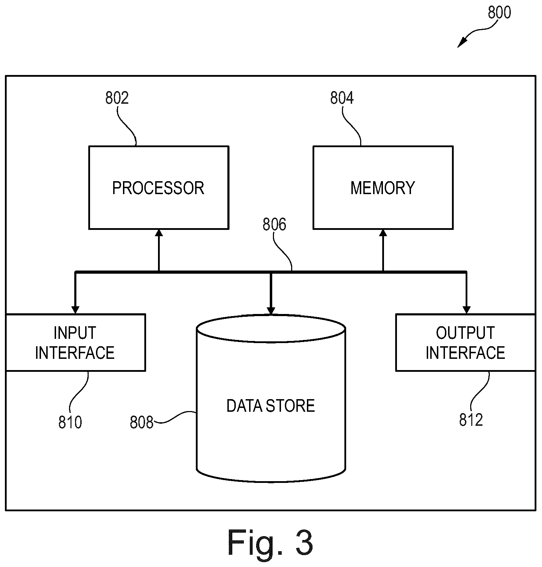

FIG. 3 illustrates an exemplary computing system 800 that can be used in accordance with the systems and methods disclosed herein. The computing system 800 may form part of or comprise any desktop, laptop, server, or cloud-based computing system. The computing system 800 includes at least one processor 802 that executes instructions that are stored in a memory 804. The instructions may be, for instance, instructions for implementing one or more of the methods described herein. The processor 802 may access the memory 804 by way of a system bus 806. In addition to storing executable instructions, the memory 804 may also store conversational inputs, scores assigned to the conversational inputs, etc.

The computing system 800 additionally includes a data store 808 that is accessible by the processor 802 by way of the system bus 806. The data store 808 may include executable instructions, log data, etc. The computing system 800 also includes an input interface 810 that allows external devices to communicate with the computing system 800. For instance, the input interface 810 may be used to receive instructions from an external computer device, from a user, etc. The computing system 800 also includes an output interface 812 that interfaces the computing system 800 with one or more external devices. For example, the computing system 800 may display text, images, etc. by way of the output interface 812.

It is contemplated that the external devices that communicate with the computing system 800 via the input interface 810 and the output interface 812 can be included in an environment that provides substantially any type of user interface with which a user can interact. Examples of user interface types include graphical user interfaces, natural user interfaces, and so forth. For instance, a graphical user interface may accept input from a user employing input device(s) such as a keyboard, mouse, remote control, or the like and provide output on an output device such as a display. Further, a natural user interface may enable a user to interact with the computing system 800 in a manner free from constraints imposed by input device such as keyboards, mice, remote controls, and the like. Rather, a natural user interface can rely on speech recognition, touch and stylus recognition, gesture recognition both on screen and adjacent to the screen, air gestures, head and eye tracking, voice and speech, vision, touch, gestures, machine intelligence, and so forth.

Additionally, while illustrated as a single system, it is to be understood that the computing system 800 may be a distributed system. Thus, for instance, several devices may be in communication by way of a network connection and may collectively perform tasks described as being performed by the computing system 800.

Various functions described herein can be implemented in hardware, software, or any combination thereof. If implemented in software, the functions can be stored on or transmitted over as one or more instructions or code on a computer-readable medium. Computer-readable media include computer-readable storage media. Computer-readable storage media can be any available storage media that can be accessed by a computer. By way of example, and not limitation, such computer-readable storage media can comprise FLASH storage media, RAM, ROM, EEPROM, CD-ROM or other optical disc storage, magnetic disk storage or other magnetic storage devices, or any other medium that can be used to carry or store desired program code in the form of instructions or data structures and that can be accessed by a computer. Disk and disc, as used herein, include compact disc (CD), laser disc, optical disc, digital versatile disc (DVD), floppy disk, and Blu-ray disc (BD), where disks usually reproduce data magnetically and discs usually reproduce data optically with lasers. Further, a propagated signal may be included within the scope of computer-readable storage media. Computer-readable media also includes communication media including any medium that facilitates transfer of a computer program from one place to another. A connection, for instance, can be a communication medium. For example, if the software is transmitted from a website, server, or other remote source using a coaxial cable, fiber optic cable, twisted pair, digital subscriber line (DSL), or wireless technologies such as infrared, radio, and microwave, then the coaxial cable, fiber optic cable, twisted pair, DSL, or wireless technologies such as infrared, radio and microwave are included in the definition of communication medium. Combinations of the above should also be included within the scope of computer-readable media.

Alternatively, or in addition, the functionally described herein can be performed, at least in part, by one or more hardware logic components. For example, and without limitation, illustrative types of hardware logic components that can be used include field-programmable gate arrays (FPGAs), application-specific integrated circuits (ASICs), application-specific standard products (ASSPs), system-on-chip systems (SOCs), complex programmable logic devices (CPLDs), etc.

The applicant hereby discloses in isolation each individual feature described herein and any combination of two or more such features, to the extent that such features or combinations are capable of being carried out based on the present specification as a whole in the light of the common general knowledge of a person skilled in the art, irrespective of whether such features or combinations of features solve any problems disclosed herein, and without limitation to the scope of the claims. The applicant indicates that aspects of the present invention may consist of any such individual feature or combination of features.

It has to be noted that embodiments of the invention are described with reference to different categories. In particular, some examples are described with reference to methods whereas others are described with reference to apparatus. However, a person skilled in the art will gather from the description that, unless otherwise notified, in addition to any combination of features belonging to one category, also any combination between features relating to different category is considered to be disclosed by this application. However, all features can be combined to provide synergetic effects that are more than the simple summation of the features.

While the invention has been illustrated and described in detail in the drawings and foregoing description, such illustration and description are to be considered exemplary and not restrictive. The invention is not limited to the disclosed embodiments. Other variations to the disclosed embodiments can be understood and effected by those skilled in the art, from a study of the drawings, the disclosure, and the appended claims.

The mere fact that certain measures are recited in mutually different dependent claims does not indicate that a combination of these measures cannot be used advantageously.

Any reference signs in the claims should not be construed as limiting the scope.

## Claims

1. A computer-implemented method for providing real-time feedback on parameter adjustment during a medical imaging scan sequence, the method comprising:
displaying a graphical user interface for interaction with a user, wherein the graphical user interface comprises at least one input element configured to allow adjustment of at least one sequence parameter for defining the medical imaging scan sequence;
in response to adjustment of the at least one sequence parameter, determining at least one deviation of the at least one sequence parameter as adjusted from at least one corresponding standard setting;
displaying to the user real-time feedback concerning the at least one deviation via at least one output element of the graphical user interface.

2. The method as claimed in claim 1, further comprising determining an impact of the at least one deviation on a medical image to be acquired during the medical imaging scan sequence.

3. The method as claimed in claim 2, wherein the at least one output element of the graphical user interface comprises a bar with a movable marker indicating a severity of the impact.

4. The method as claimed in any preceding claim, further comprising determining an impact of the at least one deviation on an intended contrast type, wherein the at least one output element of the graphical user interface displays to the user real-time feedback concerning the determined impact on the intended contrast type.

5. The method as claimed in claim 4, wherein the determined impact on the intended contrast type comprises an amount of at least one of: T1 contrast; T2 contrast; diffusion contrast; proton density contrast.

6. The method as claimed in any preceding claim, further comprising determining an impact of the at least one deviation on at least one image quality metric, wherein the at least one output element of the graphical user interface displays to the user real-time feedback concerning the determined impact on the at least one image quality metric.

7. The method as claimed in claim 6, wherein the at least one image quality metric comprises signal-to-noise ratio, strength of contrast, undersampling artifact strength, amount of geometric distortion, spatial resolution, temporal resolution, or sensitivity to motion.

8. The method as claimed in any of claims 2-7, further comprising carrying out simulation or modelling of a medical imaging system which is to perform the medical imaging scan sequence to determine the impact of the at least one deviation.

9. The method as claimed in any preceding claim, wherein the at least one standard setting is derived from a protocol, wherein multiple versions of the protocol exist, and wherein the method further comprises selecting one of the versions of the protocol based on an image quality comparison between the multiple versions.

10. The method as claimed in any preceding claim, further comprising enabling the user to lock the at least one sequence parameter to prevent unintended adjustment thereof.

11. The method as claimed in any preceding claim, further comprising using the graphical user interface to collect user feedback concerning at least one reason for the adjustment of the at least one sequence parameter.

12. The method as claimed in any preceding claim, further comprising outputting an alert to the user concerning the at least one deviation.

13. The method as claimed in any preceding claim, further comprising storing data related to the at least one deviation as metadata with a medical image acquired during the medical imaging scan sequence.

14. A computing system configured to carry out the method as claimed in any preceding claim.

15. A computer-readable medium comprising instructions which, when executed by a computing system, cause the computing system to carry out the method as claimed in any of claims 1-13.
